# EUROPÄISCHE PATENTSCHRIFT

(11) **EP 2 777 077 B1**
(45) Veröffentlichungstag und Bekanntmachung des Hinweises auf die Patenterteilung: **30.09.2020**
(21) Anmeldenummer: 12816635.2
(22) Anmeldetag: 06.11.2012
(51) Int. Cl.: H01L 31/18

(54) **METHODE ZUR BESCHICHTUNG EINES SUBSTRATS**
METHOD FOR COATING A SUBSTRATE
PROCÉDÉ POUR REVÊTIR UN SUBSTRAT

(30) Priorität: 07.11.2011 AT 16382011
(43) Veröffentlichungstag der Anmeldung: 17.09.2014
(73) Patentinhaber: Basch, Angelika, 8010 Graz (AT)
(72) Erfinder: Basch, Angelika, 8010 Graz (AT)
(74) Vertreter: Zeuner Summerer Stütz
(86) Internationale Anmeldenummer: PCT/AT2012/000283
(87) Internationale Veröffentlichungsnummer: WO 2013/067560

(56) Entgegenhaltungen:
- EP-A2- 2 302 699
- DE-A1-102010 006 813
- US-A1- 2005 172 997
- LEE BENJAMIN G ET AL: "Light trapping by a dielectric nanoparticle back reflector in film silicon solar cells", APPLIED PHYSICS LETTERS, AIP, AMERICAN INSTITUTE OF PHYSICS, MELVILLE, NY, US, Bd. 99, Nr. 6, 8. August 2011 (2011-08-08) , Seiten 64101-64101, XP012151587, ISSN: 0003-6951, DOI: 10.1063/1.3615796 [gefunden am 2011-08-09] in der Anmeldung erwähnt
- BERGER ET AL: "Commercial white paint as back surface reflector for thin-film solar cells", SOLAR ENERGY MATERIALS AND SOLAR CELLS, ELSEVIER SCIENCE PUBLISHERS, AMSTERDAM, NL, Bd. 91, Nr. 13, 5. Juni 2007 (2007-06-05), Seiten 1215-1221, XP022104552, ISSN: 0927-0248 in der Anmeldung erwähnt
- ZI OUYANG ET AL: "Nanoparticle-enhanced light trapping in thin-film silicon solar cells", PROGRESS IN PHOTOVOLTAICS: RESEARCH AND APPLICATIONS, Bd. 19, Nr. 8, 21. Juli 2011 (2011-07-21), Seiten 917-926, XP055084921, ISSN: 1062-7995, DOI: 10.1002/pip.1135
- ANGELIKA BASCH ET AL: "Enhanced light trapping in solar cells using snow globe coating", PROGRESS IN PHOTOVOLTAICS: RESEARCH AND APPLICATIONS, Bd. 20, Nr. 7, 15. Mai 2012 (2012-05-15), Seiten 837-842, XP055084876, ISSN: 1062-7995, DOI: 10.1002/pip.2240
- BASCH A ET AL: "Combined plasmonic and dielectric rear reflectors for enhanced photocurrent in solar cells", APPLIED PHYSICS LETTERS, AIP, AMERICAN INSTITUTE OF PHYSICS, MELVILLE, NY, US, Bd. 100, Nr. 24, 11. Juni 2012 (2012-06-11), Seiten 243903-243903, XP012156596, ISSN: 0003-6951, DOI: 10.1063/1.4729290 [gefunden am 2012-06-13]

## Beschreibung

### Anwendungsbereich

Die Erfindung bezieht sich auf die Verwendung einer Methode auf einem Substrat mit einem Material eine Schicht zu bilden, die sich aus dispergierten Partikeln aus einer flüssigen Phase absetzt.

### Beschreibung

Es ist bekannt, dass Materialien mit hohem Brechungsindex (wie Titandioxid oder TiO₂) als Reflektoren im Lichtmanagement für optoelektronische Baugruppen und photovoltaische Anwendungen geeignet sind.

In "Optical intensity of light in layers of silicon with rear diffuse reflectors" (J. E. Cotter, Journal of Applied Physics (1998) 84(1) 618-624) wird beschrieben, dass pigmentierte oder strukturierte dielektrische Schichten an der Rückseite einer dünnen polykristallinen Siliziumsolarzelle, für Lichtmanagement verwendet werden können, um die Eigenschaften der Zelle zu erhöhen. Der Vorteil der beschriebenen diffusen Reflektoren sind: erstens, sie beschädigen die Siliziumoberfläche nicht; zweitens, Licht, dass beim ersten Durchtritt nicht von der dünnen Siliziumschicht absorbiert wird, wird zurückreflektiert; drittens, diffus reflektiertes Licht läuft in einem schrägen Einfallswinkel zur Oberfläche und erhöht damit den durchschnittlich zurückgelegten Weg durch die Siliziumschicht; viertens, ein Bruchteil des diffusen Lichts, das die Vorderseite erreicht, kann wieder durch totale innere Reflexion in die Siliziumschicht reflektiert werden.

In "Light Trapping in Silicon Film Solar Cells with Rear Pigmented Dielectric Reflecots" (J. E. Cotter, R. B. Hall, M. G. Mauk and A. M. Barnett, Progress in Photovoltaics: Research and Applications (1999) 7 261-274) beschreibt die Anwendbarkeit von pigmentierten dielektrischen Reflekoren (wie TiO₂) in einem Medium wie Öl oder Latex basierendem Bindemittel. Die Eigenschaften für das Lichtmanagement hängen von der Größe, dem Volumenanteil der pigmentierten Partikel und dem komplexen Brechungsindex von sowohl dem Pigment als auch dem Medium ab. Die meisten Materialien, die sich als Medium eignen haben einen relativ niedrigen Brechungsindex, der sich im moderaten Lichtmanagement äußert.

In der Veröffentlichung "Commercial white paint as back surface reflector for thin film solar cells" (O. Berger, D. Inns, A. G. Aberle, Solar Energy Materials and Solar Cells (2007) 91 1215-1221) wird kommerziell erhältliche weiße Farbe als diffuser Rückreflektor einer kristallinen Dünnfilmsiliziumsolarzelle beschrieben, die zu einen erhöhten Kurzschlussstrom führt. Die Farbe zeigte bessere Eigenschaften als Rückreflektor als Aluminium, Luft, TCO (transparente leitfähige Oxidschicht)/ Aluminiumblock oder ein freistehender Aluminiumspiegel. Pigmentierte Materialien verfügen über hohe optische Reflexion über einen weiten Wellenlängenbereich.

In der Veröffentlichung "Light trapping by a dielectric nanoparticle back reflector in film silicon cells" (B. G. Lee, P. Stradins, D. L. Young, K. Alberi, T.-K. Chuang, J. G. Couillrad and H. M. Branz, Applied Physical Letters (2011) 99 064101) wird eine Methode beschrieben um dielektrische Partikel aus Materialien hohen Brechungsindex (TiO₂) für Lichtmanagement als Rückreflektoren an Dünnschichtsolarzellen abzuscheiden. Die Nanopartikel werden in deionisiertem Wasser bei pH 10 (weit vom isoelektrischen Punkt) dispergiert. Die daraus resultierenden Kolloide werden tropfenweise auf das Substrat gegossen und getrocknet. Die daraus resultierende Beschichtung zeigt verbesserte Eigenschaften als jener weißer Farbe. Die Beschichtung ist frei von Bindemittel niedrigen Brechungsindex und weist daher einen signifikant höheren Brechungsindex als Farbe auf.

Der Erfindungsgegenstand ist ein alternativer Prozess zur Herstellung einer Beschichtung, bestehend aus Material hohen Brechungsindex, die durch die Absetzung von dispergierten Partikeln aus flüssiger Phase auf einem Substrat abgeschieden wird.

### Erfindungsgegenstand

Die Erfindung betrifft das Verfahren nach Anspruch 1.

Die gemäß Anspruch 1 abgeschiedene Schicht besteht zu mindestens 90 Gew-% aus einem Material M1 mit hohem Brechungsindex. Sie kann für Lichtmanagement verwendet werden um die relativ schwache Absorption des Lichts in der Nähe und unterhalb der Bandlücke eines Halbleiters (z.B. 1.1eV für Silizium) zu überwinden. Die Beschichtung aus Material hohen Brechungsindex ist frei von Bindemitteln und verursacht bei Lichteinstrahlung erhöhte Bildung von Elektronen-Loch Paaren im Halbleiter. Das Erhöhte Einfangen von Licht kann durch das Messen der externen Quanteneffizienz (EQE) nachgewiesen werden.

Es ist bekannt, dass Materialien hohen Brechungsindex in nichtwässrigen Medium (polar wie unpolar) dispergiert werden können.

Mit dem vorherigen Wissensstand konnten Materialien hohen Brechungsindex nicht in pH neutralen Medium abgeschieden werden. Ein besonderer Vorzug der Erfindung ist die Verwendung von pH neutralen Dispersionen.

Der Beschichtungsprozess kann in einer Flüssigkeit L1 durchgeführt werden.

Bevorzugt ist die Flüssigkeit L1 aus wässrigen und nichtwässrigen (polar und/oder unpolar) oder einer Mischung aus selbigen gewählt

Bevorzugt ist das anorganische Material aus Materialien hohen Brechungsindex wie Oxiden, Nitriden, Sulfiden, Phosphiden, Arseniden, Carbiden oder einer Kombination selbiger gewählt.

In einer bevorzugten Ausführungsform der Erfindung wird das anorganische Material M1 aus der Gruppe von TiO₂ (LiO₂, MgO, Diamant, ZnO (2.4) ZnO₂ (2.15-2.18), KNbO₃ 2.28, SiC (2.65-2.69) HgS (3.02), GaP (3.5) GaAs (3.92), SnO) oder einer Kombination selbiger gewählt. Mit dieser Methode wird die Beschichtung, die für Lichtmanagement verwendet wird direkt auf dem Substrat abgeschieden.

In einer bevorzugten Ausführungsform der Erfindung besteht das Material aus TiO₂ (Rutil, Anatas, Brookit).

In einer bevorzugten Ausführungsform der Erfindung wird die Konzentration M1 in der Flüssigkeit L1 so gewählt, das die abgeschiedene Schicht dichter ist als die mittlere freie Weglänge von Photonen und der Grossteil des einfallenden Lichts zurückreflektiert wird.

Ein weiterer Vorteil der Methode liegt in der Kombination mit anderen Lichtmanagementmethoden wie plasmonischer Nanopartikel oder Beugungsgitter.

Weiters zeigt die Beschichtung diffuse Reflexion, was für Solarzellen einen generellen Vorteil darstellt.

Weiters ermöglicht die Methode die Verwendung großer Partikel, die effektivere Lichtstreuung ermöglichen. Mit vorherigem Wissenstand war es nicht möglich Partikel mit vergleichbarer Größe zur Wellenlänge des einfallenden Lichts und darüber hinaus zu verwenden. Statt dessen mussten diese in eine (Öl oder Latex) basierten Bindemittel eingebettet werden. Das führt zu dem Vorteil das dispergierte Partikel eine vergleichbare Größe zur Wellenlänge des einfallenden Lichts und darüber hinaus haben.

### Kurzbeschreibung der Abbildungen

Abbildung 1 zeigt in der Flüssigkeit L1 dispergierte Partikel hohen Brechungsindex M1, die, nach dem Absetzen, eine Schicht frei von Bindemitteln formen.
Abbildung 2 zeigt die externe Quanteneffizienz (EQE) einer unbeschichteten (rote, gestrichelte Linie), einer mit Farbe beschichteten (schwarze, gepunktete Linie) und einer mit M1 in einer bevorzugten Ausführungsform beschichteten (blaue, durchgehende Linie) Solarzelle.
Abbildung 3 zeigt ein Schema einer Schicht aus Partikeln hohen Brechungsindex M1 frei von Bindemitteln kombiniert mit anderen Lichtmanagementmethoden wie plasmonische Nanopartikel.

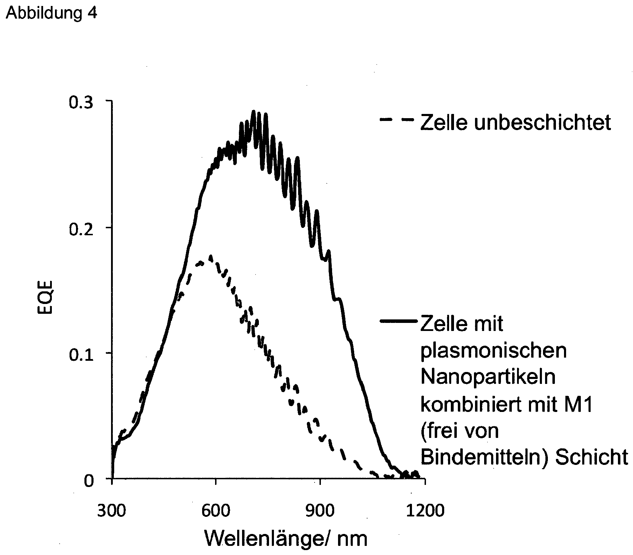

Abbildung 4 zeigt die externe Quanteneffizienz (EQE) einer unbeschichteten (rote, gestrichelte Linie) und einer mit M1 in einer bevorzugten Ausführungsform beschichteten (grüne, durchgehende Linie) Solarzelle über im Anwendungsbereich bekannten plasmonischen (z.B Silber) Nanopartikeln.

### Bevorzugte Ausführungsform der Erfindung

Eine bevorzugte Ausführungsform der Erfindung wird nachfolgend beschrieben.

Das Material M1 ist ein Pigment hohen Brechungsindex.

Die Flüssigkeit L1 ein wässriges oder nicht-wässriges Lösemittel oder eine Kombination selbiger.

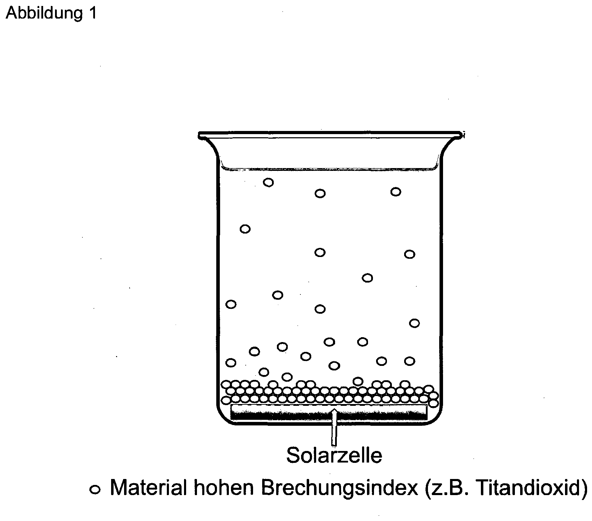

Abbildung 1 zeigt ein Schema der Abscheidungsmethode in der Material hohen Brechungsindex M1 dispergiert in einer Flüssigkeit L1 eine Schicht frei von Bindemitteln bildet.

M1 Partikel ohne Bindemittel werden verwendet. Die Partikel werden in einer ausreichenden Menge von Flüssigkeit L1 mit Hilfe eines Ultraschallbads dispergiert. Das Substrat wird (mit dem hinteren Teil nach oben) in ein Gefäß ausreichender Größe gelegt und mit der Suspension übergossen. Nach dem Absetzen der Partikel wird die beschichtete Zelle vorsichtig aus dem Gefäß gezogen und an Luft getrocknet.

Zwei Beispiele sind in Tabelle 1 zusammengefasst. In Beispiel 1 wird eine einzelne Schicht auf einem Substrat abgeschieden während in Beispiel 2 die Schicht mit im Anwendungsbereich bekannten plasmonischen metallischen (Silber) Nanopartikeln kombiniert werden. Die Schichten werden nachträglich abgeschieden um eine reflektierende Schicht für photovoltaische oder andere photoelektrische Bauteile herzustellen.

**Tablle 1**

| Prozess Parameter | Beispiel 1 | Beispiel 2 |
|---|---|---|
| M1 | TiO₂ | TiO₂ |
| Partikelgröße | 1µm | 1µm |
| L1 | Wasser | Wasser |
| Konzentration M1 (Gewichtsprozent) | 5% | 5% |
| Volumen L1 | 1000ml | 1000ml |
| pH | 6-7 | 6-7 |
| Zeit im Ultraschallbad | 15min | 15min |
| Absetzzeit | 2h | 2h |
| Substrat | polykristalline Siliziumsolarzelle | polykristalline Siliziumsolarzelle beschichtet mit plasmonischen Silberpartikeln |

Die aufgelisteten Parameter in Tabelle 1 beziehen sich auf die Abscheidung des Material hohen Brechungsindex M1. Herstellungsparameter von plasmonischen Nanopartikeln und der polykristallinen Solarzelle werden in der Tabelle nicht angeführt da diese im Anwendungsbereich bekannt sind.

Beide Beispiele führen zu hoch reflektierenden Schichten hohen Brechungsindex ohne Bindemitteln.

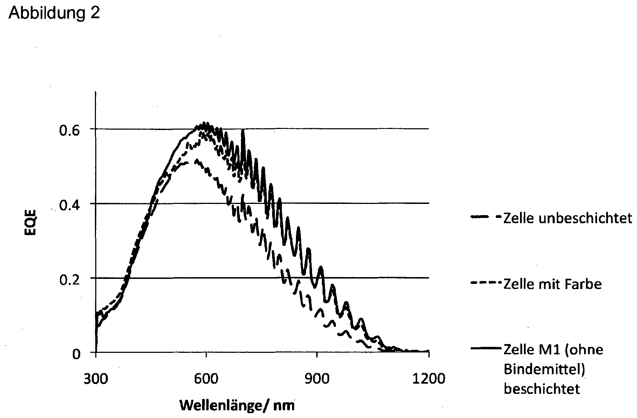

Abbildung 2 zeigt die Verbesserung der externen Quanteneffizienz (EQE) einer Solarzelle mit einer Beschichtung aus Material hohen Brechungsindex hergestellt mit einer bevorzugten Ausführungsform der Erfindung (Beispiel 1). Die Verbesserung ist signifikant höher als die von im Handel erhältlicher Farbe.

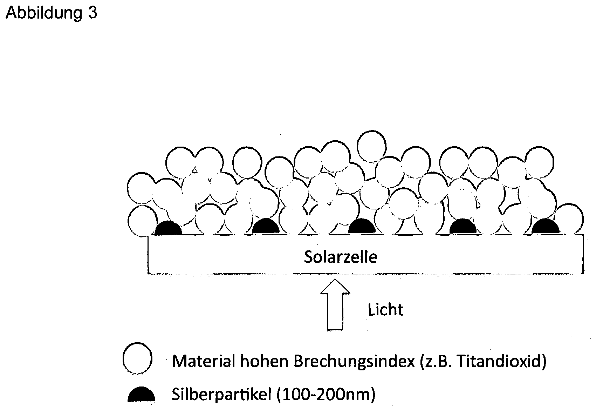

Abbildung 3 zeigt die Erhöhung der externen Quanteneffizienz (EQE) einer Solarzelle mit einem pigmentierten dielektrischen Partikelfilm abgeschieden in einer bevorzugten Ausführungsform der Erfindung in Kombination mit anderen Lichtmanagementmethoden wie plasmonische metallische Partikel (Beispiel 2).

Die Methode ist besonders zuträglich im Wellenlängenbereich von 400 - 600 nm. Eine Verbesserung der Solarzelleneigenschaften kann bis 1200 nm festgestellt werden.

Im Falle von Wasser kommt es zu keiner Schädigung des Substrats oder der elektrischen Kontakte.

## Patentansprüche

1. Verfahren zum Abscheiden einer Schicht aus abgeschiedenen Partikeln auf einem Substrat, bei dem die abgeschiedene Schicht zu mindestens 90 Gew-% aus einem Material mit hohem Brechungsindex besteht, wobei bei dem Verfahren
- eine Suspension durch Dispergieren von Partikeln ohne Bindemittel in einer Flüssigkeit hergestellt wird,
- wobei die Partikel einen hohen Brechungsindex aufweisen sowie eine Größe zumindest in der Größenordnung der Wellenlänge des einfallenden Lichts, welche im Bereich von 400 nm bis 1200 nm liegt,
- wobei die Partikel zur Herstellung einer pH-neutralen Suspension ohne Bindemittel in einem pH neutralen Medium dispergiert werden, und
- die Suspension derart auf das Substrat aufgebracht wird, dass auf dem Substrat durch Absetzen fester Partikel in einer flüssigen Phase eine bindemittelfreie Schicht aus abgeschiedenen Partikeln entsteht, die zu mindestens 90 Gew-% aus dem Material mit hohem Brechungsindex besteht, nämlich, dass die Suspension auf das Substrat aufgebracht wird, indem
- das zu beschichtende Substrat in einen Behälter gelegt und mit der Suspension übergossen wird,
- die in der Suspension dispergierten Partikel auf dem Substrat absetzen gelassen werden, und
- das Substrat in horizontaler Lage aus dem Behälter gezogen und getrocknet wird.

2. Verfahren nach Anspruch 1, **dadurch gekennzeichnet, dass** zur Herstellung der Suspension Partikel aus einem anorganischen Material aus der Gruppe der Oxide, Nitride, Sulfide, Phosphide, Arsenide, Carbide oder einer Kombination selbiger verwendet werden.

3. Verfahren nach Anspruch 1, **dadurch gekennzeichnet, dass** zur Herstellung der Suspension Partikel aus einem anorganischen Material ausgewählt aus der Gruppe von TiO₂, LiO₂, MgO, Diamant, ZnO, ZnO₂, KNbO₃, SiC, HgS, GaP, GaAs oder SnO, verwendet werden.

4. Verfahren nach Anspruch 1, **dadurch gekennzeichnet, dass** zur Herstellung der Suspension Partikel aus einem anorganischen Material verwendet werden, die aus einer der Modifikationen von TiO₂ gewählt sind.

5. Verfahren nach Anspruch 1, **dadurch gekennzeichnet, dass** als Substrat eine Solarzelle gewählt wird.

6. Verfahren nach Anspruch 1, **dadurch gekennzeichnet, dass** ein Substrat gewählt wird, das plasmonische Nanopartikel oder Beugungsgitter enthält.

7. Verfahren nach Anspruch 1, **dadurch gekennzeichnet, dass** die Schicht in einer Schichtdicke auf dem Substrat abgeschieden wird, die größer als die mittlere freie Weglänge von Photonen ist, so dass der Großteil des einfallenden Lichts von der Schicht reflektiert wird.

## Claims

1. A method for depositing a layer of deposited particles on a substrate, in which at least 90% by weight of the deposited layer consists of a material with a high refractive index, wherein in the method
- a suspension is produced by dispersing particles in a liquid without a binder,
- wherein the particles have a high refractive index as well as a dimension which is at least of the order of magnitude of the wavelength of the incident light which is in the range from 400 nm to 1200 nm,
- wherein in order to produce a pH-neutral suspension, the particles are dispersed in a pH-neutral medium without binders, and
- the suspension is applied to the substrate in a manner such that a binder-free layer of deposited particles is formed on the substrate by settling of solid particles in a liquid phase, at least 90% of the layer consisting of a material with a high refractive index, namely such that the suspension is applied to the substrate, wherein
- the substrate to be coated is placed in a container and the suspension is poured over it,
- the particles dispersed in the suspension are allowed to settle on the substrate, and
- the substrate is withdrawn from the container and dried in a horizontal position.

2. The method according to claim 1, **characterized in that** in order to produce the suspension, particles of an inorganic material from the group formed by oxides, nitrides, sulphides, phosphides, arsenides, carbides or a combination thereof are used.

3. The method according to claim 1, **characterized in that** in order to produce the suspension, particles of an inorganic material selected from the group formed by TiO₂, LiO₂, MgO, diamond, ZnO, ZnO₂, KNbO₃, SiC, HgS, GaP, GaAs or SnO are used.

4. The method according to claim 1, **characterized in that** in order to produce the suspension, particles of an inorganic material are used which are selected from any one of the modification of TiO₂.

5. The method according to claim 1, **characterized in that** a solar cell is selected as the substrate.

6. The method according to claim 1, **characterized in that** a substrate is selected which contains plasmonic nanoparticles or diffraction gratings.

7. The method according to claim 1, **characterized in that** the layer is deposited on the substrate in a layer thickness which is larger than the mean free path of photons, so that the majority of the incident light is reflected by the layer.

## Revendications

1. Procédé de dépôt d'une couche à partir de particules que l'on dépose sur un substrat, ladite couche déposée étant constituée à au moins 90 % en poids d'un matériau ayant un indice de réfraction élevé, ledit procédé consistant à
- préparer une suspension en dispersant des particules, sans liant, dans un liquide,
- lesdites particules ayant un indice de réfraction élevé ainsi qu'une taille qui se situe au moins dans l'ordre de grandeur de la longueur d'onde de la lumière incidente, laquelle est comprise entre 400 nm et 1200 nm,
- lesdites particules étant dispersées, sans liant, dans un milieu ayant un pH neutre afin de préparer une suspension ayant un pH neutre, et
- appliquer ladite suspension sur ledit substrat de manière à ce que le dépôt de particules solides au sein d'une phase liquide provoque la formation, à partir des particules déposées, d'une couche exempte de liant laquelle est constituée à au moins 90 % en poids dudit matériau ayant un indice de réfraction élevé, la suspension étant en effet appliquée sur le substrat
- en posant le substrat à revêtir dans un récipient et en versant la suspension dessus,
- en laissant les particules, qui sont dispersées dans la suspension, se déposer, et
- en retirant le substrat, en position horizontale, du récipient et en le séchant.

2. Procédé selon la revendication 1, **caractérisé en ce que** on met en œuvre, pour préparer ladite suspension, des particules constituées d'un matériau inorganique issu du groupe des oxydes, des nitrures, des sulfures, des phosphures, des arséniures, des carbures ou de l'une de leurs combinaisons.

3. Procédé selon la revendication 1, **caractérisé en ce que** l'on met en œuvre, pour préparer ladite suspension, des particules constituées d'un matériau inorganique choisi dans le groupe de TiO₂, LiO₂, MgO, diamant, ZnO, ZnO₂, KNbO₃, SiC, HgS, GaP, GaAs ou de SnO.

4. Procédé selon la revendication 1, **caractérisé en ce que** l'on met en œuvre, pour préparer ladite suspension, des particules constituées d'un matériau inorganique choisi parmi les espèces modifiées de TiO₂.

5. Procédé selon la revendication 1, **caractérisé en ce que** l'on choisit une cellule solaire comme substrat.

6. Procédé selon la revendication 1, **caractérisé en ce que** l'on choisit un substrat contenant des nanoparticules plasmoniques ou des réseaux de diffraction.

7. Procédé selon la revendication 1, **caractérisé en ce que** l'on dépose ladite couche sur le substrat dans une épaisseur de couche qui est supérieure au libre parcours moyen de photons, faisant en sorte que la majeure partie de la lumière incidente soit réfléchie par la couche.
